# EUROPEAN PATENT APPLICATION

(11) **EP 1 469 598 A1**
(43) Date of publication of application: **20.10.2004**
(21) Application number: 01275063.4
(22) Date of filing: 20.12.2001
(51) Int. Cl.: H03H 7/19, H03H 11/18, H03B 27/00, H03M 5/16, H03B 19/03, H03B 19/16

(54) **ANALOGUE SYSTEM OF GENERATING QUADRATURE SIGNALS**

(71) Applicant: Universidad de Barcelona, 08028 Barcelona (ES)
(72) Inventor: Lopez Villegas, José M., E-08970 Sant Joan Despi (Barcelona) (ES); Samitier i Marti, Josep, E-08028 Barcelona (ES); Cabanillas Costa, Josep, E-07007 Palma de Mallorca (ES)
(74) Representative: Gislon, Gabriele
(86) International application number: PCT/ES2001/000497
(87) International publication number: WO 2003/055064

(57) **Abstract**

The invention relates to an analogue system of generating quadrature signals. The inventive system comprises: a) a first analogue frequency divider; and b) a second analogue frequency divider.Each of said dividers is supplied respectively with a d₁ and d₂ analogue signal having a frequency 2f, said signals (d₁ and d₂) being 180 ° phase shifted relative to each other. In this way, two analogue output quadrature signals s₁ and s₂ having frequency f are obtained at the output of each of the aforementioned frequency dividers, i. e. said signals are 90 ° phase shifted relative to each other. The aforementioned signals (d₁ and d₂) are obtained using a differential transformer (1). Moreover, each of the above-mentioned analogue frequency dividers can be formed, from the connection with the end of the auxiliary differential transformer (1), using an inverting transformer (2, 2a), two variable-capacity varactor diodes (3, 4, 3a, 4a), which are connected to the end of each of the windings of the inverting transformer (2, 2a), and a non-inverting transformer (5, 5a).

## Description

### Field of the invention

This invention relates to an analog generator system for releasing quadrature signals using frequency division as an essential operating principle.

The availability of quadrature analog signals is essential for the correct operation of the current communications electronic systems, namely for the RF communication systems (as the best exponent we could consider the GSM, UMTS digital mobile telephony systems). In the said electronic systems, the information is coded as symbols which are constructed suitably matching phase and quadrature signals.

### Background of the invention

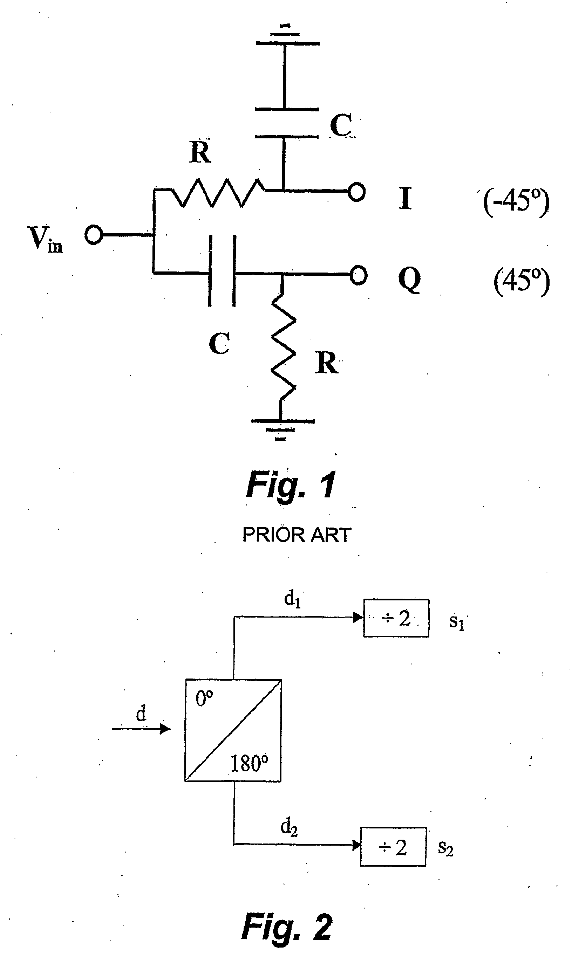

The usual way to obtain quadrature signals is by means of a shift networks. The principle which appears illustrated in Fig. 1 of the drawings attached is simple: a same signal is introduced in two networks which provoke a shift of respectively 45° and -45°. Therefore, the respective output signals will have a 90° shift. However, the phase networks have a behaviour strongly depending on the frequency this determining that the quadrature signals generation is limited to a very narrow frequency band.

The patent US 5,983,082 relates to a generator system releasing quadrature signals which uses the principle of the frequency division but it makes it by means of a digital frequency divider (assembly Flip-Flop master slave). In addition it does not directly use the quadrature signals released but it uses only one of them and an additional shift network. Last, the system implemented mandatorily requires to be polarized to operate.

The patent US 5,808,499 relates to a generator system releasing quadrature signals which like the former, also uses the principle of the frequency division but although it uses a double frequency input analog signal, releases digital signals. In addition, as it occurs in the system of the patent US 5,983,082, the polarization is also essential to correctly operate.

The patent US 5,491,725 relates to a generator system releasing quadrature signals which does not use the frequency division principle because it uses a filtering and shift match to release the said quadrature signals.

The patent US 5,808,498 discloses a phase displacement circuit which can be used as a part of a system generating quadrature clock signals. The said signals are digital and are not released using the frequency division principle.

The patent US 6,157,235 relates to a system releasing quadrature signals which do not use the principle of the frequency division. In addition, the generator is not analog but digital.

The generation pattern proposed by the invention is fully analog and does not pose above problem of dependence on the frequency of the quadrature signals released because ideally quadrature signals could be released for any frequency, although in the practise, as it will be seen, the range of useful frequency will be conditioned by the characteristics of analog frequency dividers used.

### Short explanation of the invention

This invention provides a system for releasing two quadrature signals including two analog frequency dividers respectively driven by two opposed phase signals obtained in the preferred version by an analog inverter.
The steps of the system can be schematized as follows:
1.- A frequency signal d twice the end working frequency wished feeds the single input of an analog inverter. At its output then two analog signals are obtained which are called herein d₁ and d₂ of double frequency, one with same sign as the input signal and the other with the opposite sign to that of the input signal, that is to say, with a 180° shift from each other;
2.- Then, the first signal d1 is injected to a frequency divider and the second signal d2 is injected to another frequency divider. The said dividers are independent and identical therefore they act exactly in same way on their respective inputs.

The outputs s₁ and s₂ are analog signals which for the above mentioned have exactly the same frequency except that they have a 90° shift, that is to say they are quadrature signals.

The principle by which the quadrature is achieved after the division into frequency is mathematically explained below:
1.- From the first frequency divider, it is obtained:

| | |
|---|---|
| input signal | output signal |
| e^{j2wt} | e^{jwt} |

2.- From the second frequency divider, it is obtained:

| | |
|---|---|
| input signal | output signal |
| e^{j2wt+/-π} | e^{jwt+/-π/2} |

Therefore, the output signals of the two frequency dividers are at +/- 90° shift (+/-π /2).

In an example of possible embodiment of the invention, which provides a fully passive assembly, the said frequency dividers are constituted from connecting with the end of the secondary of the differential transformer, by an inverter transformer, two varactor diodes having a variable capacity connected to the end of each winding of the said inverter transformer and a no inverter transformer.

To best understand the invention, examples of embodiment thereof will be described which have to be considered for illustrating no limiting purpose.

### Short explanation of the drawings

Fig. 1 shows a phase network for generating quadrature signals, according to the prior art.
Fig. 2 is a diagram showing the principle of the invention.
Fig. 3 illustrates an example of embodiment of the generator of the invention which can constitute a fully analog passive assembly where in addition every voltage signal at different points of the system are displayed.
Fig. 4 is a variation of the implementation of the frequency dividers used.
Fig. 5 shows the bandwidth of the generator of Fig. 3, where the polarization effect of the varactor diodes is indicated.
Fig. 6 illustrates the shapes of the voltage waves at the outputs of the quadrature generator of Fig. 3.

### Explanation of details of the examples of embodiment

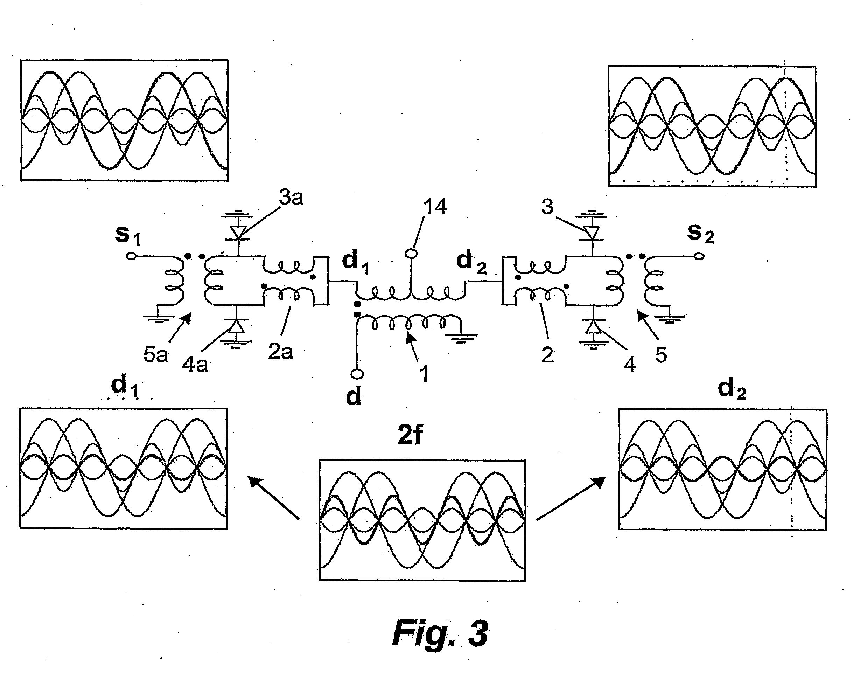

As illustrated in Fig. 2 and 3, the analog generator system of quadrature signals according to the invention is characterized in that it comprises a first analog frequency divider and a second analog frequency divider each of them fed by a d₁ and d₂ signals, respectively which are analog, of frequency 2f and with a 180° shift between them so that two output signals s₁ and s₂ are obtained which are analog, with a f frequency and which are quadrature signals (that means with a 90° shift between them).

To be able to obtain the said signals d₁ and d₂, with a 180° shift to each other, in the example proposed in Fig. 3 an inverter is used fed by a voltage signal d. The said inverter is characterized in that it is constituted by a single differential transformer 1 at the ends of its secondary winding are respectively associated the said first and second frequency dividers.

Anyway, a 180° shift could be achieved using an analog inverter (operational with inverting configuration) , a differential transformer or a coupler built with micro-strip or co-planar lines, depending on the operating frequency. Another possibility would be to directly use as input a generator having a differential output. Any of the said assemblies would be suitable for the purpose of this invention although a solution has been chosen for simplicity's sake of the assembly in addition to other properties which are described below.

Thus, the inverter 1 chosen has the property of being passive therefore it has to distribute the capacity of the input signal at 2f to a given extent between the two output signals, for example, it could distribute it fifty-fifty, constituting by itself an attenuation with respect to the input signal, in addition to be able to introduce other attenuations due to the losses or other effects.

An active device could be included at some suitable point of the system which would contribute the power required to offset the said attenuation. With respect to the already mentioned first and second frequency dividers in the example of Fig. 3, they are constituted, each, from the connection with the end of the secondary of the differential transformer 1, by an inverter transformer 2, 2a, two varactor diodes having a variable capacity 3, 4, 3a, 4a, connected with the end of each of the windings of the said inverter transformer 2, 2a and a no inverter transformer 5, 5a.

It must be emphasized that the said first and second frequency dividers are identical, which determines a symmetry in the architecture because the output signals have same capacity and frequency, although they are quadrature signals.

With respect to the bandwidth of the system, be understood as the frequency range within which the device behaves as wished, this system is specially designed to work within the frequency range of radio frequency (RF) comprised within approximately 100 MHz and 3 GHz. It is worth to say that due to the fact that the shift is not obtained with the use of phase networks a greater bandwidth is available than in other systems which do use them.

From above stated up to now, and as the system does not include any digital device or component at its input or output, it results that it is a fully analog system.

In a preferred implementation all above transformers used as well at the shift step as at the frequency division step will be planar and printed on PCB or directly on the integrated circuit.

In the example explained in Fig. 3, the system is passive, that means, it does not require an external polarization in the classical meaning (which defines it as a contribution of additional power allowing the system to suitably operate), but however, it does optionally admit the use of an external polarization applied to an outlet 14 located at an intermediate point of the secondary winding of the differential transformer 1 (which constitutes the already mentioned inverter) to displace the working frequency band.

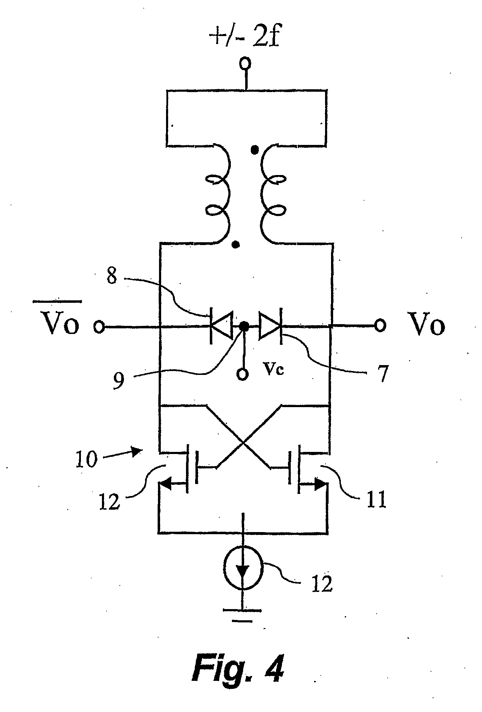

In Fig. 4, an alternative embodiment is illustrated of each of the mentioned analog frequency dividers in which the said first and second frequency dividers are constituted from connecting with the end of the secondary of the differential transformer 1 by an inverter transformer 6, two varactors diodes having a variable capacity 7, 8 connected to the end of each winding of the said inverter transformer 6 and in addition arranged in line, connected in opposition, providing a middle point 9 for controlling the capacity though a voltage Vc and a step of gain constituted by a circuit 10 with a global behaviour providing a negative differential impedance so that the said step of gain is applied to offset the losses and to increase this way the sensitivity of the quadrature generator, taking the output signals at terminals of the said varactor diodes.

As illustrated in the said Fig. 4, the said circuit 10 having a global behaviour contributing a negative differential impedance is constituted by a crossed pair of transistors 11, 12 and a power supply 13.

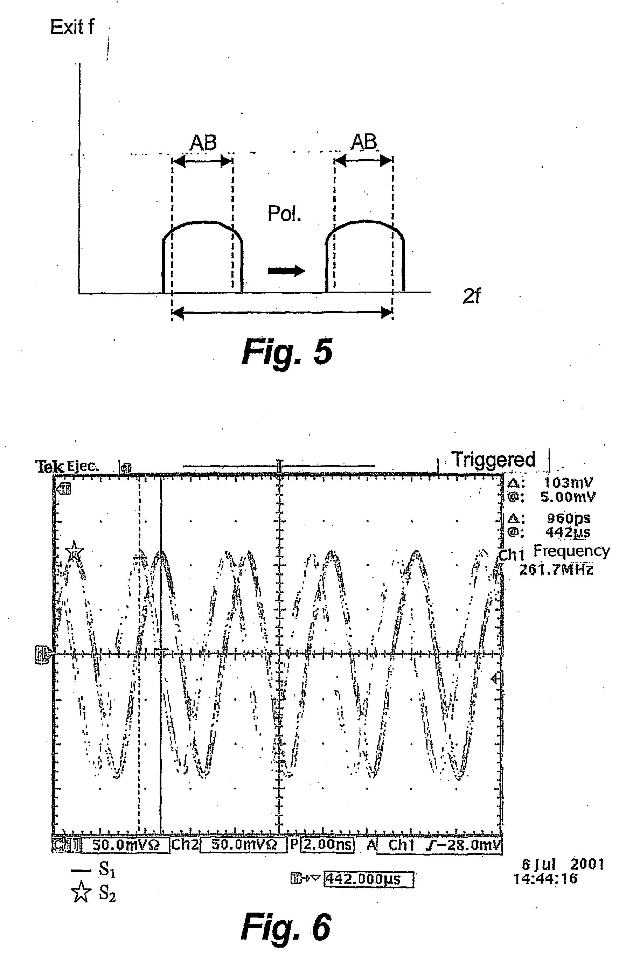

Fig. 6 illustrates the said output signals s₁ and s₂ displayed in an oscilloscope screen.

The invention could be embodied with different implementations on the ground of the accessory modifications mentioned, namely at the step releasing the said signals d₁ and d₂ with a 180° shift.

## Claims

1. Analog generator system for releasing quadrature signals **characterized in that** it comprises:
a) a first analog frequency divider;
b) a second analog frequency divider;
each of them fed by a d₁ and d₂ signals, respectively which are analog, of frequency 2f and the said signals d₁ and d₂ having a 180° shift between them so that, at the output of each of the said first and second frequency dividers, two output signals s₁ and s₂ are obtained which are analog, with a frequency f and which are quadrature signals, that means with a 90° shift between them.

2. System, according to claim 1, **characterized in that** it comprises an inverter which is fed by an input signal d, having a frequency 2f provides the said signals d₁ and d₂ having a frequency 2f and a 180° shift between them.

3. System, according to claim 2, **characterized in that** the said inverter is passive and distributes the capacity of the input signal 2f to a given extent between the two output signals.

4. System, according to claim 3, **characterized in that** the said inverter is constituted by a differential transformer (1).

5. System, according to claim 4, **characterized in that** the said first and second frequency dividers are connected to the respective ends of the secondary winding of the said differential transformer (1).

6. System, according to claim 5, **characterized in that** the said first and second frequency dividers are constituted by a step of tuning to the frequency wished.

7. System, according to claim 6, **characterized in that** the said first and second frequency dividers are constituted, each, from the connection with the end of the secondary of the differential transformer (1), by an inverter transformer (2, 2a), two varactor diodes having a variable capacity (3, 4, 3a, 4a), connected with the end of each of the windings of the said inverter transformer (2, 2a) and a no inverter transformer (5, 5a).

8. System, according to claim 6, **characterized in that** the said first and second frequency dividers are constituted, each, from the connection with the end of the secondary of the differential transformer (1), by an inverter transformer (6), two varactor diodes having a variable capacity (7,8), connected with the end of each of the windings of the said inverter transformer (6) and arranged in line, connected in opposition, providing a middle point (9) for controlling the capacity though a voltage Vc and a step of gain constituted by a circuit (10) with a global behaviour providing a negative differential impedance so that the said step of gain is applied to offset the losses and to increase this way the sensitivity of the quadrature generator, taking the output signals at terminals of the said varactor diodes (7,8).

9. System, according to claim 8, **characterized in that** the said circuit (10) with a global behaviour providing a negative differential impedance is constituted by a crossed pair of transistors (11, 12) and a power supply (13).

10. System, according to claim 7 or 8, **characterized in that** the said first and second frequency dividers are identical, which determines a symmetry in the architecture and the quadrature output signals have same capacity and frequency.

11. System, according to claim 4, **characterized in that** it includes an outlet (14) for applying an external polarization at an intermediate point of the secondary winding of the differential transformer (1) of the inverter allowing to displace through it the working frequency band.

12. System, according to claims 4 and 5, **characterized in that** all above transformers are planar and printed on PCB or directly on the integrated circuit.
